# EUROPEAN PATENT SPECIFICATION

(11) **EP 0 821 038 B1**
(45) Date of publication and mention of the grant of the patent: **13.08.2003**
(21) Application number: 97305590.8
(22) Date of filing: 25.07.1997
(51) Int. Cl.: C08L 83/04, H01L 23/29, C08L 83/05, C08L 83/07

(54) **Curable silicone composition and method for manufacturing electrical parts**
Härtbare Silikonzusammensetzungen und ein Verfahren zur Herstellung von elektrischen Teilen
Composition durcissable de silicone et un procédé de fabrication des pieces électriques

(30) Priority: 26.07.1996 JP 21518796
(43) Date of publication of application: 28.01.1998
(73) Proprietor: Dow Corning Toray Silicone Company, Ltd., Tokyo, 100 (JP)
(72) Inventor: Isshiki, Minoru, Dow Corning Toray Silicone Co.Ltd, Ichihara-shi, Chiba Prefecture (JP); Mine, Katsutoshi, Dow Corning Toray, Ichihara-shi, Chiba Prefecture (JP); Yamakawa, Kimio, Dow Corning Toray, Ichihara-shi, Chiba Prefecture (JP)
(74) Representative: Kyle, Diana

(56) References cited:
- EP-A- 0 357 802
- EP-A- 0 407 585
- EP-A- 0 510 608
- EP-A- 0 596 534
- EP-A- 0 599 532
- EP-A- 0 768 342
- EP-A- 0 789 057
- WO-A-86/01458
- GB-A- 2 208 650
- US-A- 4 122 246
- US-A- 4 208 503

## Description

The present invention claims a method for manufacturing an electrical part. More specifically, our invention provides an efficient method for manufacturing an electrical part with superior reliability in which a cured silicone resin, covering an electrical element, is bonded to a sealing resin that covers said cured silicone resin.

Electrical elements, such as integrated circuits of the types known as monolithic, hybrid, and large scale integration (IC, hybrid IC and LSI) transistors; diodes; capacitors and resistors, are generally covered with a sealing resin to protect such elements from external stresses, such as bends and impacts, and to prevent water penetration into such elements. To protect an electrical element from internal stresses caused by expansion and contraction of a sealing resin, the elements are usually covered with a cured silicone resin. In such electrical parts, however, the cured silicone resin is typically not bonded to the sealing resin. As a result, the reliability of such electrical parts is poor.

To solve this problem, many electrical parts have been proposed in which the surface of the cured silicone resin is first subjected to an ultraviolet (UV) irradiation treatment, and then this UV treated resin is sealed by means of a sealing resin, so the cured silicone resin covering the electrical part is integrally bonded to said sealing resin. This prior art is represented by JP-A 62-500106, 64-27249, 1-94679, 2-27756 and 3-22553. However, even in these electrical parts, the cured silicone resin covering the electrical part is not sufficiently bonded to said sealing resin. As a result, the reliability of such electrical parts is also unsatisfactory.

A number of curable organopolysiloxane compositions are disclosed in the prior art which employ the addition reaction of silicon-bonded alkenyl radicals with silicon-bonded hydrogen atoms in the presence of an addition catalyst and include additives to impart beneficial properties on the composition. EP 0 768 342 employs an epoxy-functional compound and a compound having at least one hydroxy group in the same molecule as a silicon hydride, alkenyl or acryl substituent and an adhesion promoter to improve adhesion to a substrate, such as an electronic component. US patent 4,122,246 employs a polysiloxane having at least one silicon-bonded hydroxyl radical and at least two silicon-bonded vinyl radicals per silicon-bonded hydroxyl radical and at least two silicon-bonded vinyl radicals per molecule in a specific range to reduce discolouration of the composition on ageing. EP 0 510 608 employs a polysiloxane having at least one silicon-bonded hydroxyl radical and at least one silicon-bonded vinyl radical per molecule and a silane having at least one epoxy-containing organo group and a silicon-bonded alkoxy group as well as an inhibitor to improve adhesion to a substrate at low temperature. EP 0 599 532 employs a combination of an adhesion promoting composition and a platinum catalyst inhibiting composition to provide good adhesion as well as good storage properties for the uncured composition. EP 0 596 534 employs an adhesion promoting additive and an organotitanium compound to provide a composition which has good initial adherence to a substrate and is durable at high temperature and high humidity. However, none of these documents provides a method for improving the adhesion of a sealing resin to a cured composition on an electrical, or any other, substrate which has been pretreated by UV radiation.

The object of the present invention is to provide an efficient method for manufacturing an electrical part with superior reliability in which a cured silicone resin that covers an electrical element is integrally bonded to, and integrated with, a cured sealing resin that covers said cured silicone resin.

Herein, our electrical element is first covered by a silicone resin which is then cured and thereafter subjected to UV treatmentto integrally bond said silicone resin to a cured sealing resin that covers the surface of said silicone resin. The cured silicone resin is made by curing an addition curable silicone composition that comprises a mixture of: (a) an organosiloxane with silanol groups and (b) an alkoxysilane with epoxy groups, and/or (c) an organosiloxanerepresented by the formula

(R¹SiO_{3/2})ₐ(R² ₂SiO_{2/2})_{b}(R² ₃SiO_{1/2})_{c}(R³O_{1/2})_{d.}

or a reaction product of (a) and (b) wherein R¹ indicates a monovalent organic group containing an epoxy group; R² indicates a substituted or unsubstituted monovalent hydrocarbon group which may be the same or different; R³ indicates an alkyl group with 1 to 4 carbon atoms; a, b, and d are respective positive numbers; and c is 0 or a positive number.

Furthermore, the method of our invention for manufacturing an electrical part comprises an electrical element that is covered with the above addition curable silicone composition.

Figure 1 is a sectional view of a semiconductor device constitutingan electrical part of the present invention.

Figure 2 is a partially sectional perspective view of a capacitor constituting an electrical part of the present invention.

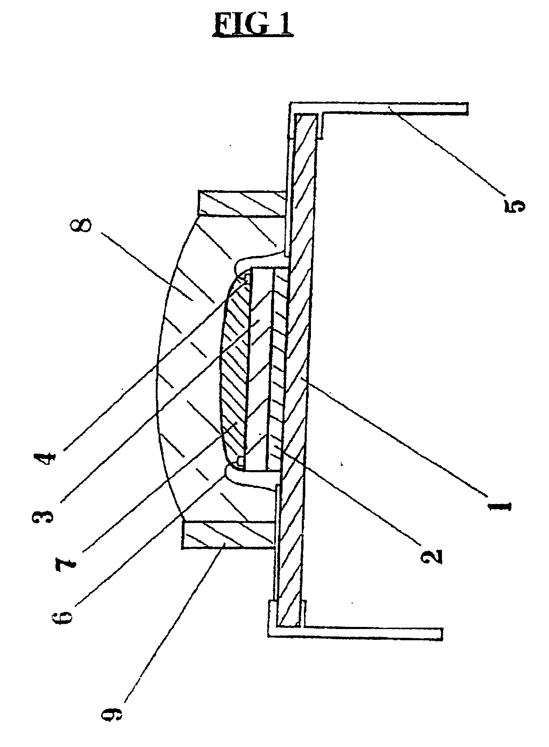

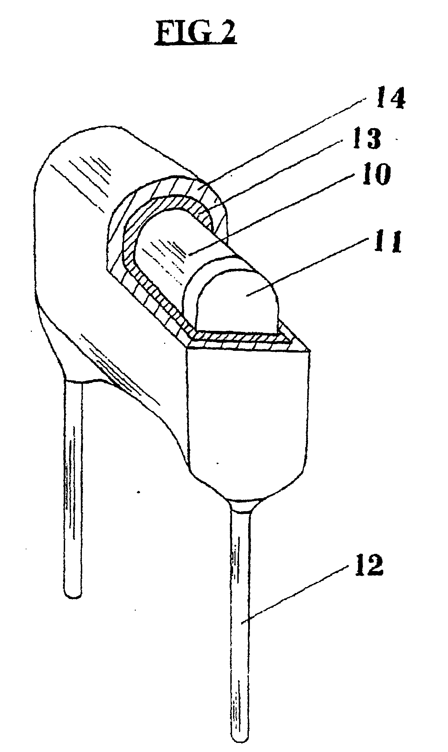

The electrical part of our invention comprises a cured silicone resin that covers an electrical element which is integrally bonded to a cured sealing resin that covers the surface of said cured silicone resin. The term "electrical element" describes electrical elements, such as transistors, resistors, capacitors and diodes; electrical devices containing such electrical elements; semiconductor elements such as IC's, hybrid IC and LSI's, or semiconductor devices containing such semiconductor elements. As the electrical element in the present invention, semiconductor devices and capacitors are especially preferred. Such a semiconductordevice is shown in Figure 1, and an example of a capacitor an electrical element is shown in Figure 2.

In Figure 1, a semiconductorelement 3 is mounted on a circuit board 1 by a bonding agent 2. Bonding pads 4 are installed on the upper end portions of the semiconductor element 3, and external leads 5 are installed on the end portions of the circuit board 1. The bonding pads 4 are electrically connected to the circuit board 1 by bonding wires 6. The semiconductor element 3 is covered by a cured silicone resin 7, and said cured resin is covered by a cured sealing resin 8. Furthermore, a frame 9 is installed around the periphery of the semiconductor element 3 to prevent the sealing resin from flowing out. Moreover, the surface of the cured silicone resin 7 is subjected to UV treatment, and the resin 7 is thereafter thoroughly bonded to, and integrated with, the cured sealing resin 8 covering said silicone resin.

In Figure 2, a capacitor [comprising a polyester film 10 on which aluminum has been vacuum-evaporated(metallized)] is wrapped or laminated. Electrodes 11 are then formed by covering both ends of said wrapped or laminated film with a flame-coated metal and are electrically connected to external leads 12. This capacitor is next covered by a cured silicone resin 13, and said resin is covered by a cured sealing resin 14. Furthermore, the surface of the cured silicone resin 13 is subjected to UV treatment, is thereby thoroughly bonded to, and integrated with, the cured sealing resin 14 that covers said silicone resin.

The addition curable silicone composition used in the method of the present invention comprises:
(A) an organopolysiloxane having an average of at least two alkenyl groups bonded to silicon atoms in each molecule;
(B) an organohydrogenpolysiloxanehaving an average of at least two hydrogen atoms bonded to silicon atoms in each molecule;
(C) an addition reaction catalyst; and
(D) mixture of (a) an organosiloxane with silanol groups and (b) an alkoxysilane with epoxy groups, and/or (c) an organosiloxane expressed by the formula

   (R¹SiO_{3/2})ₐ(R² ₂SiO_{2/2})_{b}(R² ₃SiO_{1/2})_{c}(R³O_{1/2})_{d}

   or the reaction product of (a) and (b) wherein R¹, R², R³, a, b, d and c are as described above.

The preferred organopolysiloxane of component (A) has at least two silicon-bonded alkenyl groups per molecule. Examples of alkenyl groups in component (A) include vinyl, allyl, butenyl, pentenyl, hexenyl and heptenyl. The bonding positions of the alkenyl groups may be on the ends of the molecular chains and/or on molecular side chains. Furthermore, examples of groups other than alkenyl groups which are bonded to silicon atoms in component (A) include substituted or unsubstituted monovalent hydrocarbon groups, e. g., alkyl groups such as methyl, ethyl, propyl, butyl, pentyl, hexyl and heptyl; aryl groups such a phenyl tolyl, xylyl and naphthyl; aralkyl groups such as benzyl or phenethyl; and halogenated alkyl groups such as chlommethyl, 3-chloropropyl and 3,3,3-trifluoropropyl. Furthermore, the molecular structure of component (A) may be linear, linear with some branching, completely branched cyclic or net-form. Moreover, it is desirable that the viscosity of component (A) at 25°C be in the range of 5 to 1,000,000 mPa.s (centipoise).

The organohydrogenpolysiloxaneof component (B) is a cross linking agent for our composition, and has at least two silicon-bonded hydrogen atoms per molecule. The bonding positions of these hydrogen atoms may be on the ends of the molecular chains and/or on molecular side chains. Furthermore, examples of groups other than hydrogen atoms which are bonded to silicon atoms in component (B) include substituted or unsubstituted monovalent hydrocarbon groups as identified above. The molecular structure of component (B) may be linear, linear with some branching, completely branched cyclic or net-form. Moreover, it is desirable that the viscosity of component (B) at 25°C be in the range of 1 to 100,000 mPa.s (centipoise). The amount of component (B) that is added to this composition is an amount sufficient to cause curing of the composition. It is preferred that the amount added will provide molar ratio of silicon-bondedhydrogen atoms in component (B) to silicon-bonded alkenyl groups in component (A) of from 0.4 to 10. A molar ratio is from 0.5 to 3.0 is more preferred. If the molar ratio of silicon-bonded hydrogen atoms in component (B) to silicon-bonded alkenyl groups in component (A) is less than 0.4, the claimed composition tends to show insufficient curing. If the molar ratio exceeds 10, the mechanical strength of the cured silicone resin obtained is unsatisfactory.

The addition reaction catalyst of component (C) promotes the curing of our composition. Examples of such catalysts are platinum catalysts such as platinum black, platinum supported on silica, platinum supported on active carbon, alcohol solutions of chloroplatinic acid, olefin complexes of platinum or alkenylsiloxane complexes of platinum, as well as similiar rhodium and palladium catalysts. The amount of component (C) that is added to this composition is a catalytic amount. It is preferred that the amount added provide a metal concentration of 0.1 to 1,000 ppm (in weight units) based on the total composition.

Component (D) is used to insure sufficient bonding of the ultraviolet irradiation treated cured silicone resin to the cured sealing resin. This component is a mixture of components (a) and (b), and/or (c) or the reaction product of (a) and (b).

Component (a) is a silanol group containing organosiloxane. A silanol group is a hydroxy group bonded to a silicon atom. In preferred embodiments, component (a) is an organosiloxanehaving an average of at least two silanol groups per molecule. The molecular structure of component (a) may be linear, linear with some branching, completely branched, cyclic or net-form. A linear structure is preferred. Examples of organic groups which may be bonded to the silicon atoms in component (a) include substituted or unsubstituted monovalent hydrocarbon groups, e. g., alkyl groups such as methyl, ethyl, propyl, butyl, pentyl, hexyl and heptyl.; aryl groups such phenyl, tolyl, xylyl and naphthyl; aralkyl groups such as benzyl or phenethyl and halogenated alkyl groups such as chloromethyl, 3-chloropropyland 3,3,3-trifluoropropyl. In particular, methyl, vinyl and phenyl are groups preferred. Examples of component (a) include silanol-terminateddimethylpolysiloxanes, silanol-tetminateddimethylsiloxane-methylvinylsiloxanecopolymers and silanol-terminated dimethylsiloxane-methylphenylsiloxanecopolymers.

Component (b) is an epoxy group containing alkoxysilane. Examples of such alkoxysilanes include alkoxysilanes having the general formula

R¹Si(OR⁴)₃

wherein R¹ is as described above. In preferred embodiments, R¹ is selected from the group consisting of glycidoxyalkyl, epoxycyclohexylalkyland oxiranylalkyl. Preferred glycidoxyalkyl groups include 3-glycidoxypropylor 4-glycidoxybutyl. Preferred epoxycyclohexylalkyl groups include 2-(3,4-epoxycyclohexyl)ethylor 3-(3.4-epoxycyclo-hexyl)propylgroups. Preferred oxiranylalkyl groups include 4-oxiranylbutyl or 8-oxiranyloctyl groups. Glycidoxyalkyl groups (such as 3-glycidoxypropyl)are especially preferred. Furthermore, R⁴ is an alkyl group with 1 to 4 carbon atoms, e. g., methyl, ethyl, propyl or butyl. In particular, a methyl group is especially preferred. Examples of compounds which are used as component (b) include 3-glycidoxypropyltrimethoxysilane,2-(3,4-epoxycyclohexyl)ethyltrimethoxysilane 4-oxiranylbutyltrimethoxysilane and 8-oxiranyloctyltrimethoxysilane. In particular, 3-glycidoxypropyltrimethoxysilaneis especially preferred.

Components (a) and (b) may be simply mixed, or caused to undergo a condensation or equilibrium reaction. It is preferred that the weight ratio of component (a) to component (b) be from 0.1 : 1 to 1 : 10.

The organosiloxane of component (c) is expressed by the formula

(R¹SiO_{3/2})ₐ(R² ₂SiO_{2/2})_{b}(R² ₃SiO_{1/2})_{c}(R³O_{1/2})_{d}

wherein R¹ R², R³, a, b, c and d are as described above. In preferred embodiments, R² is selected from the group consisting of alkyl, alkenyl, aryl, aralkyl and halogenated alkyl. Preferred alkyl groups include methyl, ethyl, propyl, butyl, pentyl, hexyl and heptyl groups. The preferred alkenyl group is vinyl. Preferred aryl groups include phenyl, tolyl, xylyl and naphthyl. Preferred aralkyl groups include benzyl or phenethyl. Preferred halogenated alkyl groups include chloromethyl, 3-chloropropyl and 3,3,3-trifluoropropyl. In particular, methyl, vinyl and phenyl groups are especially preferred. R³ is preferably selected from the group consisting of methyl, ethyl, propyl and butyl. In particular, methyl groups are especially preferred.

One example of a method which can be used to prepare component (c) is a method in which a linear or cyclic diorganosiloxane and an alkoxysilane containing epoxy groups are subjected to equilibrium polymerization in the presence of a polymerization catalyst such as sodium hydroxide, etc.

There are no particularrestrictions on the amount of component (D) that is added to our claimed composition, as long as said amount is such that the adhesion of the resulting silicone resin to the sealing resin is sufficient. However, it is preferred that the content of component (D) in our composition be from 0.01 to 20 wt % preferably from 0.1 to 20 wt %, and more preferably from 0.1 to 10 wt %. If the amount of component (D) is less than 0.01 wt. %, it becomes difficult to achieve the object of the present invention. If the added amount exceeds 20 wt. %, the mechanical strength of the cured silicone resin is unacceptable.

Optional components may be added to our claimed composition and include addition reaction inhibiting agents, e. g., acetylene compounds such as 3-methyl-l-butyn-3-ol,3,5-dimethyl-1-hexyn-3-oland 3-phenyl-1-butyn-3-ol;"enyne" type compounds such as 3-methyl-3-penten-1-yneor 3,5-dimethyl-3-hexen-1-yne; siloxane compounds containing alkenyl groups such as 1,3,5,7-tetramethyl-1,3,5,7-tetravinylcyclotetrasiloxaner 1,3,5,7-tetramethyl-1,3,5,7-tetrahexenylcyclotetrasiloxane;and triazole compounds such as benzotriazole. It is preferred that such inhibiting agents be added at the rate of 10 to 5.000 ppm (in weight units) relative to the total composition.

Examples of other optional components contained within our claimed composition include fiber-form fillers such as glass, asbestos, alumina, ceramic fibers containing alumina and silica components, boron, zirconia, silicon carbide, metal, phenol, aramide, nylon, polyester and natural animal or vegetable; and inorganic fillers such as fused silica, precipitatedsilica, fumed silica, calcined silica, zinc oxide, calcined clay, carbon black, glass beads, alumina, talc, calcium carbonate, clay, alumina hydroxide, barium sulfate, titanium dioxide, titanium oxide, aluminum nitride, silicon carbide, magnesium oxide, beryllium oxide, cerium oxide, kaolin, mica, zirconia and silicon; organic fillers such as epoxy resins, nylon resins, phenol resins, polyester resins, fluororesins and silicone resins; organic solvents such as xylene, toluene and heptane; and other additives such as dyes. heat-resistantadditives. thickeners, and pigments.

In our manufacturing method, a semiconductor element such as an IC, hybrid IC and LSI, or an electrical element such as a transistor, diode, capacitor or resistor, is covered by an addition curable silicone composition that comprises a mixture of (a) an organosiloxane with silanol groups and (b) an alkoxysilane with epoxy groups, and/or (c) an organo siloxane having the formula

(R¹SiO_{3/2})ₐ(R² ₂SiO_{2/2})_{b}(R² ₃SiO_{1/2})_{c}(R³O_{1/2})_{d}

or a reaction product of (a) and (b) wherein R¹, R², R³, a, b, c and d are as described above. When a semiconductor device such as Figure 1 is manufactured, it is first necessary to mount a semiconductor element 3 on a circuit board 1 by a bonding agent 2, and to then form electrical connections between the circuit board 1 and the bonding pads 4 located on the upper end portions of the semiconductor element 3 by means of bonding wires 6. Furthermore, in cases where a resin which possesses fluidity is used as the sealing resin, it is desirable to also install a frame 9 around the periphery of the semiconductor element 3 to prevent the sealing resin from escaping. Meanwhile, when a capacitor such as Figure 2 is manufactured, it is first necessary to wrap or laminate a polyester film 10 up, on which aluminum has been vacuum-evaporated (metallized), and then to form electrodes 11 by covering both ends of said wrapped or laminated film 10 with a flame-coated metal. Thereafter, external leads 12 must be electrically connected to electrodes 11.

The addition curable silicone composition used to cover the electrical elements is the same as described above. Methods which can be used to apply this composition to the electrical element include potting, casting, dip coating, drip coating by means of a dispenser, spray coating and brush coating. Furthermore, the method used to cure said composition on the electrical element, comprises allowing the coated element to stand at room temperature or heating the composition to a temperature of 50 to 250°C. For example, this heating is accomplishedby means of an oven, hot plate or heat lamp, or by the radiant heat generated during the UV irradiation treatment.

After the silicone compositionscure, it is irradiated with ultraviolet light. Examples of ultraviolet irradiation treatments on the surface of the cured silicone resin covering our electrical element include methods using light sources such as mercury lamp, a xenon-mercury lamp or a metal halide lamp. Furthermore, it is preferredthat the UV irradiation conditions used will prove an amount of irradiation at 254 nm of from 0.01 to 10 J/cm². If necessary, an optical filter (for UV irradiation at a specified wavelength), a thermal radiation cutting filter or reflective mirror may be installed on the light source during the UV treatment. Moreover, this UV treatment may be performed while cooling the cured silicone resin by means of an air cooling fan or a water cooling system.

Thereafter, the cured silicone resin which has been UV irradiated is sealed by a sealing resin. Examples of curable sealing resins include epoxy, phenol, polyphenylene sulfide polyether and polyimide. In particular, epoxy resins are especially preferred. Examples of such epoxy resins include glycidyl ether epoxy resins such as bisphenol A, bisphenol F, biphenyl epoxy resins, phenol novolak epoxy resins, orthocresol novolak epoxy resins and brominated epoxy resins; alicyclic epoxy resins; glycidyl ester epoxy resins; glycidylamine epoxy resins; and heterocyclic epoxy resins. Examples of curing mechanisms used in these curable epoxy resins include heat-curability, ultraviolet-curability and moisture-curability. However, heat-curability is especially preferred. Furthermore, the curable epoxy resins may be liquid at room temperature, or may be solid resins which have a softening point above room temperature. However, from the standpoint of handling and working characteristics, it is preferred that the resin be a liquid at room temperature. Methods used to apply the sealing resin to the cured and UV treated silicone resin include transfer molding, injection molding, potting, casting, dip coating, drip coating by means of a dispenser, spray coating and brush coating. Furthermore, the curing methods used to cure this sealing resin on the cured silicone resin include methods in which said sealing resin is heated to a temperature of 50 to 250°C (when the sealing resin used is heat-curable); methods in which said resin is irradiated with ultraviolet light from the aforementioned light source (when the sealing resin is ultraviolet-curable);and methods in which said resin is allowed to stand at room temperature (when the sealing resin is moisture-curable). Means used to heat the resin include for example, an oven, hot plate or heat lamp.

### Examples

The electrical part of the present invention, and the method for manufacturing the same, will now be described in detail by practical examples of application. Herein, viscosities are values measured at 25°C. Moreover, the adhesion of the cured sealing resin to the cured silicone resin and the reliability of the electrical part (semiconductor device or capacitor)were evaluated as described below.

### Preparation of Sealing Resin

The sealing resin used in the examples was prepared as follows:

A curable epoxy resin composition was prepared by uniformly mixing 100 parts by weight of an epoxy resin consisting principally of a bisphenol F epoxy resin (epoxy equivalents= 165), 120 parts by weight of a tetraalkyltetrahydrophthalic anhydride (molecular weight = 234 and used as a curing agent), and 1 part by weight of 1-isobutyl-3-methylimidazole (used as a curing accelerating agent).

### Adhesion of Cured Sealing Resin to Cured Silicone Resin

The curable silicone composition was applied to the surface of an aluminum plate, and was cured by being heated for 5 minutes in a hot air draft circulation oven at 100°C. Next, the cured silicone resin was subjected to ultraviolet (UV) irradiation by means of a high-pressuremercury lamp, lamp power = 120 W/cm so the amount of irradiation at a wavelength of 254 nm was 0.2 J/cm². Afterward, the sealing resin was applied to the surface of the UV treated cured silicone resin, and said sealing resin was cured by being heated for 4 hours in said hot air oven at 120°C. The adhesion of the cured sealing resin to the cured silicone resin was observed. Cases where the adhesion was strong were indicated by a circle; cases where some peeling occurred were indicated by a triangle; and cases where complete peeling occurred were indicated by an X.

### Reliability of Electronic Part (Semiconductor Device)

A semiconductor device of Figure 1 was constructed as follows:

A semiconductor element 3, which had an aluminum wiring pattern formed on its surface was mounted by means of a bonding agent 2 on the surface of a circuit board 1 made of an alumina ceramic. Afterward, bonding pads 4, located on the upper end portions of the semiconductor element 3, were electrically connected to the circuit board 1 by means of metal bonding wires 6. Next, the surface of this semiconductor element 3 was coated with a curable silicone composition by means of a dispenser, and a cured silicone resin 7 was formed by heating for 5 minutes in said hot air oven at 100°C. Then, the surface of this cured silicone resin 7 was irradiated with UV light by means of said high-pressure mercury lamp. Afterward, a sealing resin was applied by a dispenser to the surface of the treated cured silicone resin 7. Since this sealing resin possessed fluidity, a rubber frame 9 with a height of 1 mm was previously installed around the periphery of the semiconductor element 3. Thereafter, this assembly was heated for 4 hours in said hot air oven at 120°C, so a cured sealing resin 8 was formed on the surface of the cured silicone resin 7. thus completing a semiconductor device of this invention. 20 samples of this semiconductor device were manufactured in the same manner.

These semiconductordevices were subjected to 100 cycles of a thermal cycle test in which one cycle consisted of 30 minutes at a temperature of -30°C followed by 30 minutes at a temperature of +100°C. The rate of defective operation of the semiconductor devices following this thermal cycle test was determined.

### Reliability of Electrical Part (Capacitor)

A capacitor of Figure 2 was constructed as follows:

A polyester film 10, on which aluminum was vacuum-evaporated (metallized), was wrapped into a roll, and both ends of this roll were covered by a flame-coated metal so electrodes 11 were formed. External leads 12 were then electrically connected to these electrodes 11. Afterward, this assembly was dipped in a curable silicone composition, and the coated assembly was heated for 5 minutes in said hot air oven at 100°C so a cured silicone resin 13 was formed. Next, the surface of this cured silicone resin 13 was irradiated with UV light by said high-pressure mercury lamp. Then, this UV treated cured silicone resin 13 was dipped in a sealing resin, and the resulting assembly was heated for 4 hours in said hot air oven at 120°C so a cured sealing resin 14 was formed on the surface of the cured silicone resin 13, thus completing a capacitor of this invention. 20 samples of this capacitor were manufactured in the same manner.

These capacitors were subjected to a moisture resistance test in which the capacitors were allowed to stand for 1000 hours at 40°C in an atmosphere with a relative humidity of 95%. The rate of defective operation of the capacitors following this moisture resistance test was determined.

### Reference Example 1

116 g of 1,3,5,7-tetramethyl-1,3,5,7-tetravinylcycloetrasiloxane100 g of 3-glycidoxypropyltrimethoxysilaneand 0.05 g of potassium hydroxide were placed in a four-necked flask, equipped with an agitator, a thermometer and a reflux condenser, and these ingredients were subjected to equilibrium polymerization for 3 hours while heated and agitated at 120 °C. Afterward, this reaction was stopped with dimethyldichlorosilane. This reaction mixture was distilled under reduced pressure [100°C, 0.67 kPa (5 mm # Hg)] so the low-boiling components were removed. As a result, liquid substance was obtained. When this liquid was analyzed by Fourier transform nuclear magnetic resonance analysis, it was confirmed as an organopolysiloxaneexpressed by the following formula (1)

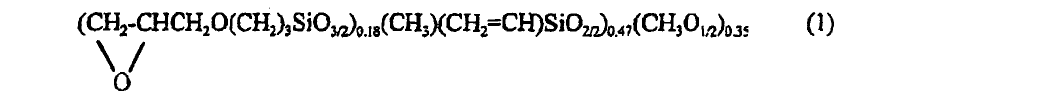

### Example 1

A curable silicone composition was prepared by uniformly mixing 96.9 parts by weight of a dimethylvinylsiloxy-terminateddimethylpolysiloxane (viscosity: 400 centipoise (mPa.s), 2.0 parts by weight of a trimethylsiloxy-terminated dimethylsiloxane-methylhydrogensiloxanecopolymer(viscosity: 5 centipoise (mPa.s), 0.5 part by weight of 3-glycidoxypropyltrimethoxysilane,0.5 part by weight of a silanol-terminateddimethylsiloxane-methylvinylsiloxane copolymer (viscosity: 25 centipoise (mPa.s), 0.1 part by weight of a a wt % isopropyl alcohol solution of chloroplatinic acid, and 0.01 part by weight of 3 - phenyl-1-butyn-3-ol(used as an inhibiting agent).

Using this curable silicone composition, the adhesion of the cured sealing resin to the cured silicone resin, and the reliability of the electronic part (semiconductor device or capacitor) was evaluated. The evaluation results are in Table 1.

### Example 2

A curable silicone composition was prepared as in Example 1, except that 1.0 part by weight of the organopolysiloxaneprepared in Reference Example 1 was used instead of 0.5 part by weight of 3-glycidoxypropyltrimethoxysilaneand 0.5 part by weight of silanol-terminated dimethylsiloxane-methylvinylsiloxane copolymer.

Using this curable silicone composition, the adhesion of the cured sealing resin to the cured silicone resin, and the reliability of the electronic part (semiconductor device or capacitor) were evaluated. The evaluation results are given in Table 1.

### Comparative Example 1

A curable silicone composition was prepared as in Example 1, except that the 0.5 part by weight of 3-glycidoxypropyltrimethoxysilaneand 0.5 part by weight of silanol-terminated dimethylsiloxane-methylvinylsiloxanecopolymer were omitted.

Using this curable silicone composition, the resins' adhesion and the reliability of the electronic part (semiconductor device or capacitor) were evaluated-The evaluation results are reported in Table 1.

### Comparative Example 2

A curable silicone composition was prepared as in Example 1. except that 0.5 part by weight of 3-glycidoxypropyltrimethoxysilane was not added.

Using this curable silicone composition the resins' adhesion, and the reliability of the electronic part (semiconductordevice or capacitor) were evaluated. The evaluation results are provided in Table 1.

### Comparative Example 3

A curable silicone composition was prepared as in Example 1. except that 0.5 part by weight of silanol-terminated dimethylsiloxane-methylvinylsiloxane copolymer was omitted.

Using this curable silicone composition, the resins' adhesion and the reliability of the electronic part (semiconductor device or capacitor) were evaluated. The evaluation results are enumerated in Table 1.

**Table 1**

| | Present Invention | | Comparative Examples | | |
|---|---|---|---|---|---|
| | Ex. 1 | Ex. 2 | Comp. Ex. 1 | Comp. Ex. 2 | Comp. Ex. 3 |
| Adhesion of cured sealing resin to cured silicone resin | 0 | 0 | X | Δ | X |
| Reliability of semiconductor device (rate of defective operation following thermal cycle test) (%) | 0 | 0 | 10 | 5 | 10 |
| Reliability of capacitor (rate of defective operation following moisture resistance test) (%) | 0 | 0 | 10 | 5 | 5 |

In the electrical part of the present invention, a cured silicone resin which covers an electrical element is thoroughly bonded to, and integrated with, a cured sealing resin which covers said cured silicone resin. Accordingly, the electrical part of this invention has superior reliability. Furthermore, the method of the present invention for manufacturing an electrical part produces an electrical part with good efficiency.

## Claims

1. A method of manufacturing an electrical part, said method comprising the steps of:
(i) providing an electrical element;
(ii) covering the electrical part with an addition curable silicone composition;
(iii) curing said curable silicone composition to form a cured silicone resin;
(iv) treating the surface of said cured silicone resin with ultraviolet radiation; and
(v) sealing the treated silicone resin with a sealing resin,
**characterised in that** the addition curable silicone composition comprises:
(A) an organopolysiloxane having an average of at least two silicon-bonded alkenyl groups per molecule;
(B) an organohydrogenpolysiloxane having an average of at least two silicon-bonded hydrogen atoms per molecule;
(C) an addition reaction catalyst: and
(D) a composition selected from the group consisting of
I. a mixture of
(a) an organosiloxane having silanol groups;
(b) an alkoxysilane having epoxy groups; and
(c) an organosiloxane having the formula
(R¹SiO_{3/2})ₐ(R² ₂SiO_{2/2})_{b}(R² ₃SiO_{1/2})_{c}(R³O_{1/2})_{d}
wherein R¹ is an epoxy containing monovalent organic group; each R² is individually selected from substituted or unsubstituted monovalent hydrocarbon groups; R³ is an alkyl group having 1 to 4 carbon atoms; a, b, and d are >0; and c is ≥ 0;
II. a mixture of components (a) and (b);
III. a mixture of components (a) and (c); and
IV. a reaction product of components (a) and (b).

2. The method of Claim 1, wherein the molar ratio of silicon bonded hydrogen atoms in component (B) to silicon-bonded alkenyl groups in component (A) is from 0.4 to 10.

3. The method of Claim 1 or Claim 2, wherein component (a) is selected from the group consisting of silanol-terminated dimethylpolysiloxanes, silanol-terminated dimethylsiloxane-methylvinylsiloxane copolymers and silanol-terminated dimethylsiloxane-methylphenylsiloxane copolymers.

4. The method of any of Claims 1 to 3 wherein component (b) is an alkoxysilane having the formula
R¹Si(OR⁴)₃
wherein R¹ is an epoxy containing monovalent organic group and R⁴ is selected from the group consisting of glycidoxyalkyl, epoxycyclohexylalkyl and oxiranylalkyl.

5. The method of Claim 4, wherein component (b) is selected from the group consisting of 3-glycidoxypropyltrimethoxysilane, 2-(3,4-epoxycyclohexyl)ethyltrimethoxysilane, 4-oxiranylbutyl-trimethoxysilane and 8-oxiranyloctyltrimethoxysilane.

6. The method of Claim 1, wherein the weight ratio of component (a) to component (b) is 0.1:1 to 1:10.

7. The method of Claim 1, wherein R² of component (c) is selected from the group consisting of alkyl, alkenyl, aryl, aralkyl, and halogenated alkyl.

8. The method of Claim 7, wherein R² is selected from the group consisting of methyl, vinyl and phenyl.

9. The method of any of Claims 1 to 8, wherein the amount of component (D) is from 0.01 to 20 wt% based on the total weight of the said curable silicone composition.

10. The method according to any preceding claim, wherein the electrical element of step (i) is selected from semiconductor elements or capacitors.

11. The method according to any preceding claim, wherein the sealing resin of step (v) is a cured epoxy resin.

12. The method according to any preceding claim, wherein the ultraviolet radiation of step (iv) has an intensity of at least 0.1 J/cm² at 254 nm.

## Patentansprüche

1. Verfahren zur Herstellung eines elektrischen Teils, wobei das Verfahren die Schritte umfasst:
(i) Bereitstellen eines elektrischen Elements;
(ii) Überziehen des elektrischen Elements mit einer additionshärtbaren Siliconzusammensetzung;
(iii) Härten dieser härtbaren Siliconzusammensetzung, um ein gehärtetes Siliconharz zu bilden;
(iv) Behandeln der Oberfläche dieses gehärteten Siliconharzes mit ultravioletter Strahlung und
(v) Versiegeln des gehärteten Siliconharzes mit einem Siegelharz,
**dadurch gekennzeichnet, dass** die additionshärtbare Zusammensetzung enthält:
(A) ein Organopolysiloxan mit durchschnittlich mindestens 2 siliciumgebundenen Alkenylgruppen pro Molekül;
(B) ein Organowasserstoffpolysiloxan mit durchschnittlich mindestens 2 siliciumgebundenen Wasserstoffatomen pro Molekül;
(C) einen Additionsreaktionskatalysator und
(D) eine Zusammensetzung, ausgewählt aus der Gruppe bestehend aus
I. einer Mischung aus
(a) einem Organosiloxan mit Silanolgruppen;
(b) einem Alkoxysilan mit Epoxygruppen und
(c) einem Organosiloxan mit der Formel
(R¹SiO_{3/2})ₐ(R² ₂SiO_{2/2})_{b}(R² ₃SiO_{1/2})_{c}(R³O_{1/2})_{d},
worin R¹ eine epoxyhaltige monovalente organische Gruppe ist; jedes R² unabhängig voneinander ausgewählt ist aus substituierten 0-der unsubstituierten monovalenten Kohlenwasserstoffgruppen; R³ eine Alkylgruppe mit 1 bis 4 Kohlenstoffatomen ist; a, b und d größer 0 sind und c ≥ 0 ist;
II. einer Mischung aus Komponenten (a) und (d);
III. einer Mischung aus Komponenten (a) und (c) und
IV. einem Reaktionsprodukt aus Komponenten (a) und (b).

2. Verfahren nach Anspruch 1, worin das Molverhältnis von siliciumgebundenen Wasserstoffatomen in Komponente (B) zu siliciumgebundenen Alkenylgruppen in Komponente (A) von 0,4 bis 10 reicht.

3. Verfahren nach Anspruch 1 oder 2, worin Komponente (a) ausgewählt ist aus der Gruppe bestehend aus silanolterminierten Dimethylpolysiloxanen, silanolterminierten Dimethylsiloxan-Methylvinylsiloxan-Copolymeren und silanolterminierten Dimethylsiloxan-Methylphenylsiloxan-Copolymeren.

4. Verfahren nach einem der Ansprüche 1 bis 3, worin Komponente (b) ein Alkoxysilan mit der Formel R¹Si(OR⁴)₃ ist, worin R¹ eine epoxyhaltige monovalente organische Gruppe ist und R⁴ ausgewählt ist aus der Gruppe bestehend aus Glycidoxyalkyl, Epoxycyclohexylalkyl und Oxiranylalkyl.

5. Verfahren nach Anspruch 4, worin Komponente (b) ausgewählt ist aus der Gruppe bestehend aus 3-Glycidoxypropyltrimethoxysilan, 2-(3-, 4-Epoxycyclohexyl)ethyltrimethoxysilan, 4-Oxiranylbutyl-Trimethoxysilan und 8-Oxiranyloctyltrimethoxysilan.

6. Verfahren nach Anspruch 1, worin das Gewichtsverhältnis von Komponente (a) zu Komponente (b) von 0,1:1 bis 1:10 reicht.

7. Verfahren nach Anspruch 1, worin R² von Komponente (c) ausgewählt ist aus der Gruppe bestehend aus Alkyl, Alkenyl, Aryl, Aralkyl und halogeniertem Alkyl.

8. Verfahren nach Anspruch 7, worin R² ausgewählt ist aus der Gruppe bestehend aus Methyl, Vinyl und Phenyl.

9. Verfahren nach einem der Ansprüche 1 bis 8, worin die Menge von Komponente (D) von 0,01 bis 20 Gew.-%, bezogen auf das Gesamtgewicht dieser härtbaren Siliconzusammensetzung, reicht.

10. Verfahren gemäß einem der vorstehenden Ansprüche, worin das elektrische Element aus Schritt (i) aus Halbleiterelementen oder Kondensatoren ausgewählt ist.

11. Verfahren nach einem der vorstehenden Ansprüche, worin das Siegelharz aus Schritt (v) ein gehärtetes Epoxyharz ist.

12. Verfahren nach einem der vorstehenden Ansprüche, worin die ultraviolette Strahlung aus Schritt (iv) eine Intensität von mindestens 0,1 J/cm² bei 254 nm aufweist.

## Revendications

1. Procédé de fabrication d'une pièce électrique, ledit procédé comprenant les étapes consistant à :
(i) fournir un élément électrique ;
(ii) recouvrir la pièce électrique d'une composition de silicone durcissable par addition ;
(iii) durcir ladite composition de silicone durcissable pour former une résine silicone durcie ;
(iv) traiter la surface de ladite résine silicone durcie par rayonnement ultraviolet ; et
(v) sceller la résine silicone durcie avec une résine de scellement,
**caractérisé en ce que** la composition de silicone durcissable par addition comprend :
(A) un organopolysiloxane ayant une moyenne d'au moins deux groupes alcényle lié au silicium par molécule ;
(B) un organohydrogènopolysiloxane ayant une moyenne d'au moins deux atomes d'hydrogène lié au silicium par molécule ;
(C) un catalyseur de réaction d'addition ; et
(D) une composition sélectionnée dans le groupe constitué de
I. un mélange de
(a) un organosiloxane ayant des groupes silanol;
(b) un alcoxysilane ayant des groupes époxy ; et
(c) un organosiloxane ayant la formule
(R¹SiO_{3/2})ₐ(R² ₂SiO_{2/2})_{b}(R² ₃SiO_{1/2})_{c}(R³O_{1/2})_{d}
où R¹ est un groupe organique monovalent contenant de l'époxy ; chaque R² est sélectionné individuellement parmi les groupes hydrocarbonés monovalents substitués ou non substitués ; R³ est un groupe alkyle ayant 1 à 4 atomes de carbone ; a, b et d sont > 0 ; et c est ≥ 0 ;
II. un mélange de composants (a) et (b) ;
III. un mélange de composants (a) et (c) ; et
IV. un produit de la réaction des composants (a) et (b).

2. Procédé selon la revendication 1, dans lequel le rapport molaire d'atomes d'hydrogène lié au silicium dans le composant (B) aux groupes alcényle lié au silicium dans le composant (A) est de 0,4 à 10.

3. Procédé selon la revendication 1 ou la revendication 2, dans lequel le composant (a) est sélectionné dans le groupe constitué des diméthylpolysiloxanes à terminaison silanol, des copolymères de diméthylsiloxane-méthylvinylsiloxane à terminaison silanol et des copolymères de diméthylsiloxane-méthylphénylsiloxane à terminaison silanol.

4. Procédé selon l'une quelconque des revendication 1 à 3, dans lequel le composant (b) est un alcoxysilane ayant la formule
R¹Si(OR⁴)₃
où R¹ est un groupe organique monovalent contenant de l'époxy et R⁴ est sélectionné dans le groupe constitué de glycidoxyalkyle, époxycyclohexylalkyle et oxiranylalkyle.

5. Procédé selon la revendication 4, dans lequel le composant (b) est sélectionné dans le groupe constitué de 3-glycidoxypropyltriméthoxysilane, 2-(3,4-époxycyclohexyl)éthyltriméthoxysilane, 4-oxiranylbutyltriméthoxysilane, et 8-oxiranyloctyltriméthoxysilane.

6. Procédé selon la revendication 1, dans lequel le rapport pondéral du composant (a) au composant (b) est de 0,1/1 à 1/10.

7. Procédé selon la revendication 1, dans lequel R² du composant (c) est sélectionné dans le groupe constitué de alkyle, alcényle, aryle, aralkyle et alkyle halogéné.

8. Procédé selon la revendication 7, dans lequel R² est sélectionné dans le groupe constitué de méthyle, vinyle et phényle.

9. Procédé selon l'une quelconque des revendications 1 à 8, dans lequel la quantité de composant (D) est de 0,01 à 20 % en poids sur la base du poids total de ladite composition de silicone durcissable.

10. Procédé selon l'une quelconque des revendications précédentes, dans lequel l'élément électrique de l'étape (i) est sélectionné parmi les éléments semi-conducteurs ou les condensateurs.

11. Procédé selon l'une quelconque des revendications précédentes, dans lequel la résine de scellement de l'étape (v) est une résine époxy durcie.

12. Procédé selon l'une quelconque des revendications précédentes, dans lequel le rayonnement ultraviolet de l'étape (iv) a une intensité d'au moins 0,1 J/cm² à 254 nm.
